# EUROPEAN PATENT APPLICATION

(11) **EP 3 882 691 A1**
(43) Date of publication of application: **22.09.2021**
(21) Application number: 20194065.7
(22) Date of filing: 02.09.2020
(51) Int. Cl.: G02F 1/1333

(54) **BACK COVER ASSEMBLY AND DISPLAY DEVICE HAVING THE SAME**

(30) Priority: 20.03.2020 KR 20200034378; 29.04.2020 KR 20200052395
(71) Applicant: Heesung Electronics Co., Ltd, Seoul 04410 (KR)
(72) Inventor: CHO, Sung Ha, 16708 Suwon-si (KR)
(74) Representative: Mollekopf, Gerd Willi

(57) **Abstract**

The present disclosure relates to a back cover assembly and a display device having the same, and the back cover assembly includes a back cover (200) configured to support a display panel (100) by bonding the display panel to a front surface thereof, and a user-defined mount (UDM) plate (300) having a module-accommodating space (310), in which a module for driving the display panel is accommodated, formed therein, and coupled to a rear surface of the back cover (200), wherein the UDM plate (300) is formed to have a stepped portion of a predetermined height (H1) between a fastening end fastened to the back cover (200) and a rear surface end (330) forming a rear surface of the UDM plate (300).

## Description

### BACKGROUND OF THE INVENTION

### (a) Field of the Invention

The present disclosure discloses a back cover assembly and a display device having the same.

### (b) Description of the Related Art

In general, display devices are devices configured to receive an image signal to display an image and include TVs, monitors, digital signage, smart phones, and the like, and as a device for displaying the image, various devices such as an organic light-emitting diode (OLED) device, a liquid crystal display (LCD) device, and a plasma display panel are used.

Recently, with development into an information society, the demand for display devices is also changing in various forms, and the display devices are gradually becoming lighter, larger, and slimmer. In particular, since the demand for large-sized displays increases in the case of a display device applied to TVs, there is an increasing demand for lightening, slimming, and aesthetics of a TV structure together with a high-quality image and a high-definition image.

In general, display devices have a structure in which a back cover supports a display panel at a rear surface of the display panel, and a backlight unit may be further interposed between the display panel and the back cover depending on the type of display panel.

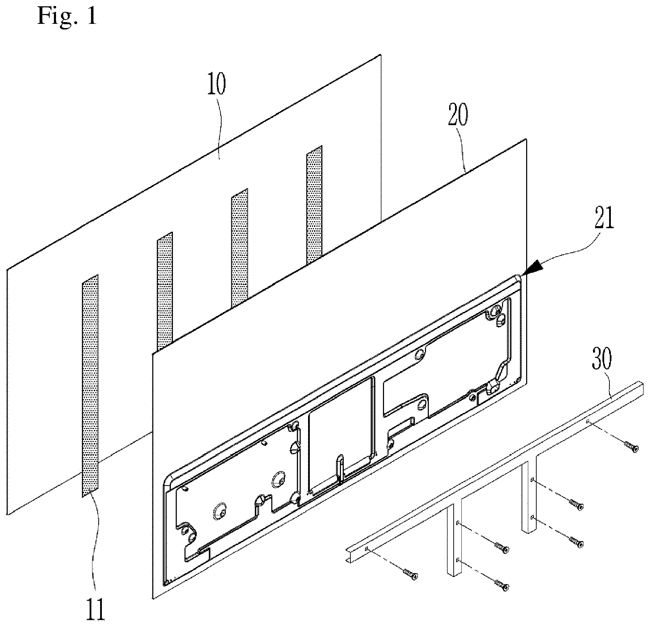

FIG. 1 is an exploded perspective view of a display device according to the related art in which a display panel 10 may be bonded to a front surface of a back cover 20 through an adhesive member 11 such as double-sided tape or a double-sided adhesive foam pad.

The back cover 20 is a plate having a rectangular shape and includes one area in which a user-defined mount (UDM) area 21 is formed so that components such as a power module and a control module are combined. The UDM area 21 is integrally formed with the back cover 20 by applying a process such as a press process or the like to one side of the plate-shaped back cover 20.

The back cover having the UDM area makes it difficult to manage plate flatness due to the forming of the UDM area and is decreased in resistance to bending deformation. That is, the back cover has a problem in that upper/left/right areas thereof are easily bent due to the forming of the UDM area. In order to prevent this, an inner plate is inserted into an inner surface of the back cover to correct the bending deformation, but it is difficult to manage the inner plate, and there is a problem in that the additional insertion of the inner plate is disadvantageous for slimming a display device and increases manufacturing costs. Furthermore, the inner plate also has been recently removed according to the trend of slimness and lightweightness, and thus the problem of bending deformation of the back cover has not been easily solved.

In order to solve such a problem, the display device includes a separate reinforcing frame 30 coupled to the UDM area 21 of the back cover 20. The reinforcing frame 30 may be composed of a plurality of unit frames joined in a lateral or vertical direction at a rear surface of the back cover 20. The reinforcing frame 30 is constituted by a rigid bar of a metal material having high strength and has a relatively great weight and thickness compared to the back cover.

Accordingly, in the display device according to the related art, since the expensive reinforcing frame is coupled, there are disadvantages in that manufacturing costs are increased, a manufacturing process and a structure are complicated, and due to the weight and thickness of the reinforcing frame, reducing weight and slimming are difficult.

Meanwhile, in the display device, the UDM area has a specific shape and structure depending on a model of a display device, and thus, when the model of a display device is changed, the entire back cover including the UDM area should be changed. Accordingly, the conventional back cover has a limit of only being applied to a display device of a specific model, and, in order to be applied to a display device of another model, a separate mold device for manufacturing a back cover should be manufactured, and thus manufacturing costs are significantly increased.

### SUMMARY OF THE INVENTION

The invention is defined in claims 1 and 9, respectively. Particular embodiments are set out in the dependent claims.

The present disclosure is directed to providing a back cover assembly enabling the rigidity of a back cover to be improved even when an inner plate or a reinforcing frame is removed by configuring a user-defined mount (UDM) plate to reinforce the rigidity of the back cover.

The present disclosure is also directed to providing a back cover assembly applicable to display devices of various models by changing only a UDM plate even when the model of the display device is changed by manufacturing the UDM plate separately from a back cover and coupling the UDM plate with the back cover.

According to an aspect of the present disclosure, there is provided a back cover assembly including a back cover configured to support a display panel by bonding the display panel to a front surface thereof; and a UDM plate having a module-accommodating space, in which a module for driving the display panel is accommodated, formed therein, and coupled to a rear surface of the back cover, wherein the UDM plate is formed to have a stepped portion of a predetermined height between a fastening end fastened to the back cover and a rear surface end forming a rear surface of the UDM plate.

The back cover may be coupled to the UDM plate by clinch bonding.

The UDM plate may be formed to have a stepped portion of 11 mm to 15 mm between the fastening end and the rear surface end.

The UDM plate may include a reinforcing rib formed by protruding an edge of the fastening end, which is fastened to the back cover, in a rear surface direction.

The reinforcing rib may be formed by bending an edge of the fastening end into a shape of "L," or formed to be convex in a shape of "U."

The reinforcing rib may be formed to have a height of 8 mm to 12 mm with respect to the fastening end.

The UDM plate may have a clean back ratio ((W1 - W2)/W1) of 6% to 9% in a lateral direction, wherein the clean back ratio is a ratio of a portion excluding a width (W2) of the UDM plate from an entire width (W1) of the back cover in the lateral direction with respect to the entire width (W1).

Color coating or painting may be performed on a surface of the back cover.

According to another aspect of the present disclosure, there is provided a display device including a display panel, a back cover configured to support the display panel by bonding the display panel to a front surface thereof, and a UDM plate having a module-accommodating space, in which a module for driving the display panel is accommodated, formed therein, and coupled to a rear surface of the back cover, wherein the UDM plate is formed to have a stepped portion of a predetermined height between a fastening end fastened to the back cover and a rear surface end forming a rear surface of the UDM plate, and the UDM plate includes a reinforcing rib formed by bending an edge of the fastening end, which is fastened to the back cover, in a rear surface direction.

### BRIEF DESCRIPTION OF THE DRAWINGS

The above and other objects, features, and advantages of the present disclosure will become more apparent to those of ordinary skill in the art by describing exemplary embodiments thereof in detail with reference to the accompanying drawings, in which:
- FIG. 1: is an exploded perspective view illustrating a display device according to the related art;
- FIG. 2: is an exploded perspective view illustrating a display device according to an embodiment of the present disclosure;
- FIG. 3: is a side view illustrating a user-defined mount (UDM) plate in detail, which is a major part of FIG. 2;
- FIG. 4: is an exploded perspective view illustrating a display device according to another embodiment of the present disclosure;
- FIGS. 5A and 5B: are cross-sectional views illustrating various examples of a reinforcing rib, which is a major part of FIG. 4;
- FIG. 6: is a side view illustrating a UDM plate in detail, which is a major part of FIG. 4; and
- FIG. 7: is a rear view illustrating the display device according to the embodiment illustrated with reference to FIG. 4.

### DETAILED DESCRIPTION OF EXEMPLARY EMBODIMENTS

The technical objectives achieved by the present disclosure and the embodiments of the present disclosure will be apparent from exemplary embodiments described below. Hereinafter, the exemplary embodiments of the present disclosure will be described in detail with reference to the accompanying drawings.

It is to be understood that the differences in the embodiments described below are not mutually exclusive. That is, it is to be understood that the specific shapes, structures, and characteristics described may be implemented in other embodiments in connection with one embodiment and that the location or arrangement of individual components within each disclosed embodiment may be changed without departing from the scope of the present disclosure. In the drawings, like reference numerals refer to the same or similar functionality throughout various aspects, and lengths, areas, thicknesses, and the like and the forms thereof may be exaggerated for convenience. In the description of the present embodiment, expressions, such as up, down, left, right, front, and rear, indicate relative positions or directions, and technical significance will not be bound by the dictionary meanings.

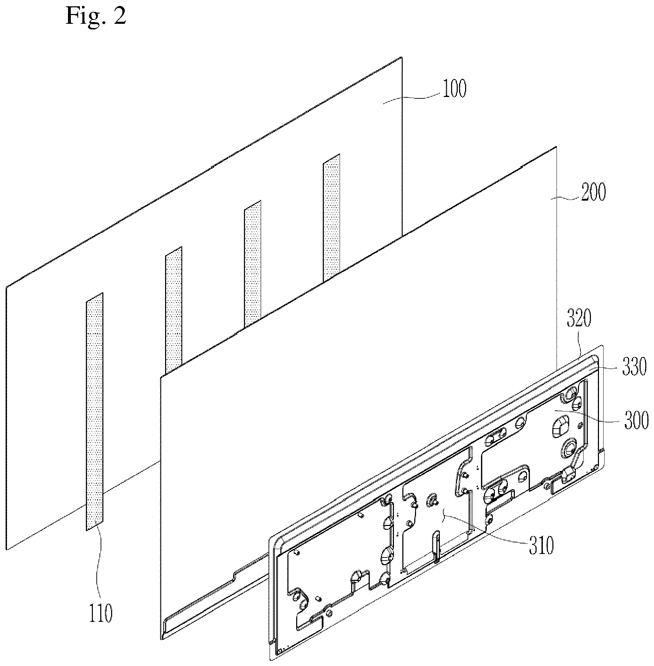

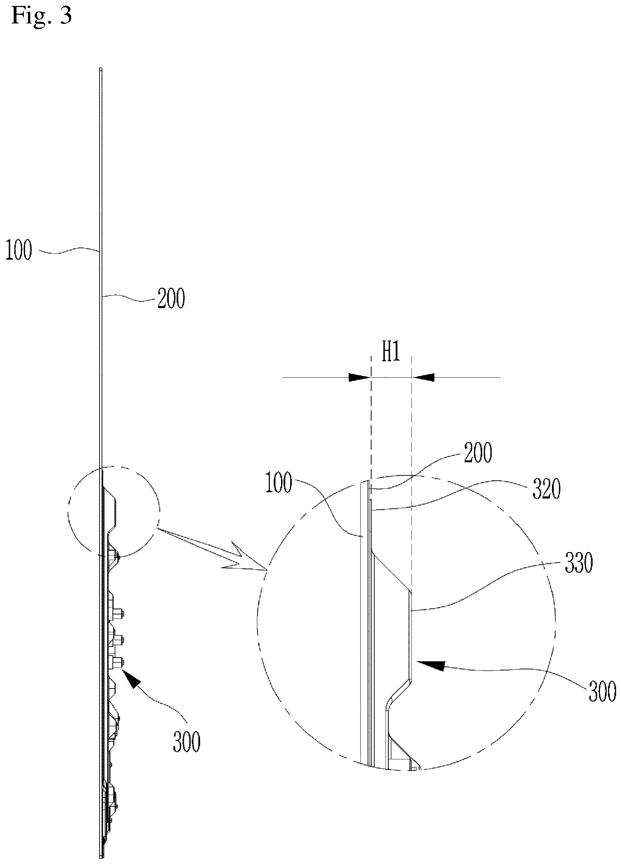

FIG. 2 is an exploded perspective view illustrating a display device according to an embodiment of the present disclosure, and FIG. 3 is a side view illustrating a user-defined mount (UDM) plate in detail, which is a major part of FIG. 2.

As illustrated in these drawings, the display device according to the present embodiment includes a display panel 100, a back cover 200 configured to receive and support the display panel 100 at a rear side of the display panel 100, and a UDM plate 300 coupled to a rear surface of the back cover 200. In the display device having the above-described configuration, the display panel 100 and the back cover 200 may be bonded with each other through a panel adhesive member 110 such as double-sided tape or a double-sided adhesive foam pad.

The display panel 100 is a key component of the display device and is an image display element configured to express an image from external signals, and may be constituted by, for example, an organic light-emitting panel. The organic light-emitting panel is advantageous for slimming and a curved surface and exhibits a fast response speed.

In addition, the display panel 100 may be constituted by various types of image display elements such as a liquid crystal panel, a plasma panel, and the like in addition to the organic light-emitting panel. When the display panel 100 is constituted by the liquid crystal panel, a backlight unit configured to provide a surface light source may be further joined with a rear surface of the liquid crystal panel.

The back cover 200 supports the display panel 100 bonded with a front surface thereof and simultaneously functions as a rear surface case of the display device. The back cover 200 may be formed in a rectangular plate shape corresponding to the shape of the display device and may have a predetermined curvature when applied to a curved display device.

The back cover 200 is made of a material that is thin and light, and has sufficient rigidity even when an inner plate or a reinforcing frame is removed. As an example, the back cover 200 may be made of a high-strength aluminum resin composite material (hereinafter, referred to as "ACM"), electrolytic galvanized iron (EGI), an aluminum plate, a reinforced plastic, or the like. In addition, the back cover 200 may be press-formed using a metal plate having a surface to which a color coating is applied, or may be press-formed and then subjected to a surface coating process using powder coating or liquid coating. The display device may be attractively decorated with such coating or painting.

The back cover 200 includes a support part 210, which has a rectangular plate shape and is configured to support the display panel 100 by being bonded with a rear surface of the display panel 100, and a guide part 220 that is formed by bending an edge of the support part 210 toward the front and configured to guide the coupling of the display panel 100 while shielding side surfaces of the display panel 100.

The guide part 220 may be formed by bending the edge of the support part 210 toward the front, and an end portion of the guide part 220 may be hemmed in an inward or outward direction and thus a width of a bezel is secured only with a thickness of the material constituting the back cover 200. Accordingly, the back cover of the present embodiment exhibits an advantageous effect in reducing the width of the bezel.

Further, a surface treatment process, such as wheel cutting, may be applied to the end portion of the guide part 220.

Further, color coating or painting may be performed on the surface of the back cover 200. The color coating or painting may be performed to shield an exterior from surface scratches or the like generated during the processing of the back cover. The painting may be performed through a powder coating process or a liquid coating process.

The UDM plate 300 is coupled to the rear surface of the back cover 200 to fix components (not shown) for driving the display panel 100 and reinforce the rigidity of the back cover 200. To this end, the UDM plate 300 may be constituted by an aluminum steel plate, a zinc steel plate, a Galvalume steel plate, and the like and may have a thickness of 0.5 mm to 1.2 mm.

In addition, the UDM plate 300 may be coupled to the back cover 200 by clinch bonding. The clinch bonding is achieved by punching the front surface of the back cover 200 in a direction of the UDM plate in a state in which the back cover 200 and the UDM plate 300 are disposed to overlap each other. Accordingly, the front surface of the back cover 200 may be maintained in a planar state and thus interference with the adhesion of the display panel 100 does not occur. In addition, the coupling of the back cover 200 and the UDM plate 300 using clinch bonding has an advantage in that bonding strength may be easily controlled by adjusting the positions at which the clinch bonding is performed or the number of applications of the clinch bonding.

Further, the UDM plate 300 includes a module-accommodating space 310 having a concave shape at an inner surface thereof to accommodate various control modules, such as a TC module, a power module, a graphic module, and the like, or components, and the module-accommodating space 310 is formed by forming the plate-shaped UDM plate 300 using a process such as pressing. The module-accommodating space 310 may be divided into a plurality of areas depending on the required number or type of components.

The shape and structure of the UDM plate 300 may be specified according to a model of the display device. That is, when the model for the same inch (cm) display device is changed, a specific model of the UDM plate 300 corresponding to the corresponding model of the display device is selected and coupled to the back cover 200. Accordingly, in the display device of the present embodiment, the back cover may be used as it is even when a new same inch (cm) model is manufactured, thereby reducing mold costs.

Further, the UDM plate 300 of the present embodiment is formed to have a stepped portion of a predetermined height H1 between a fastening end 320, which is brought into contact with and fastened to the back cover 200, and a rear surface end 330 forming an outer periphery of the rear surface of the UDM plate 300. The stepped portion may be formed in the module-accommodating space.

The UDM plate 300 of the present embodiment accommodates components and simultaneously is coupled to the rear surface of the back cover 200 to reinforce the rigidity of the back cover 200, and the performance of reinforcing the rigidity of the back cover 200 may vary according to the above-described forming height H1. The reinforcing performance of the UDM plate 300 of the present embodiment with respect to the back cover 200 will be described in detail through an experiment below.

### <Experiment 1>

In Experiment 1, a restoration amount for the bending deformation of the back cover 200 according to the forming height H1 of the UDM plate 300 of the present embodiment was compared with that of the conventional back cover, and the results are shown in Table 1. In Experiment 1, a central portion area of a 50-inch (127 cm) back cover was pressurized with a force of 5 kgf (kilogram-force (49.33 N)), and then a deflection amount and a restoration amount were measured.

Further, as the conventional back cover, a back cover (Comparative Example 1), which includes a UDM plate integrally formed therewith, includes a rear surface to which a separate reinforcing frame is joined in a shape of " " or "-", and has a forming height of 10 mm, was targeted. In addition, as the UDM plate 300 of the present embodiment, UDM plates 300 formed with a stepped portion having the height H1 of 10 mm (Experimental Example 1), 12 mm (Experimental Example 2), and 15 mm (Experimental Example 3) were targeted.

**[Table 1]**

| Evaluation items | | Comparative Example 1 (1 0mm) | Experimental Example 1 (1 0mm) | Experimental Example 2 (12mm) | Experimental Example 3 (15mm) |
|---|---|---|---|---|---|
| Deflection amount at center portion (mm) | | 28.64 | 29.68 | 28.45 | 27.12 |
| Deformation amount after restoration (mm) | | 22.12 | 23.44 | 21.48 | 19.97 |
| Restoration amount | (mm) | 6.52 | 6.24 | 6.97 | 7.15 |
| | (%) | 23% | 21% | 24% | 26% |

Referring to Table 1, in the case in which the forming height of the UDM plate 300 was 10 mm, the back cover of Comparative Example 1 according to the related art was restored by as much as 6.52 mm after being deflected by 28.64 mm in a central portion thereof, showing a restoration rate of 23%, but the back cover of Experimental Example 1 according to the present embodiment was restored by as much as 6.24 mm after being deflected by 29.68 mm in a central portion thereof, showing a restoration rate of 21%, which shows that it was rather easily deformed and the restoration was not well performed. This is because the reinforcing plate was removed in Experimental Example 1 for the same forming height (HI = 10 mm). However, the back cover of Experimental Example 2, in which the forming height H1 was increased to 12 mm, according to the present embodiment was restored by as much as 6.97 mm after being deflected by 28.45 mm in a central portion thereof, showing a restoration rate of 24%, and the back cover of Experimental Example 3, in which the forming height was increased to 15 mm, was restored by as much as 7.15 mm after being deflected by 27.12 mm in a central portion thereof, showing a restoration rate of 26%. Accordingly, it can be seen that when the forming height H1 of the UDM plate 300 increases as in the present embodiment, the restoration amount increases as the deflection amount (deformation amount) decreases so that the restoration rate is significantly improved.

In general, when the stepped portion between the fastening end 320 and the rear surface end 330, that is, the forming height H1 is in a range of 11 mm to 15 mm, the UDM plate 300 is advantageous for slimming and exhibits an excellent effect in the reinforcement of rigidity. When the forming height H1 is less than 11 mm, the rigidity reinforcing effect is lowered, and when the forming height H1 is greater than 15 mm, the rigidity reinforcing effect is excellent but it is disadvantageous for slimming and reducing weight.

As described above, the UDM plate 300 of the present embodiment is coupled to the back cover 200 to reinforce the rigidity of the back cover 200, thereby minimizing bending deformation, and particularly, the UDM plate 300 has an effect of preventing bending deformation and significantly increasing the restoration amount when compared with the UDM integrated back cover in the related art.

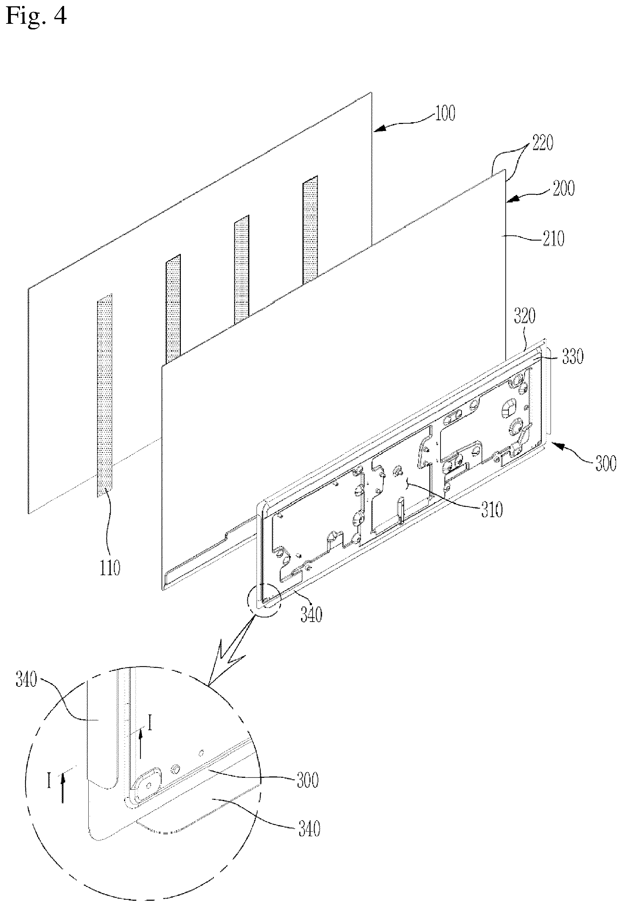

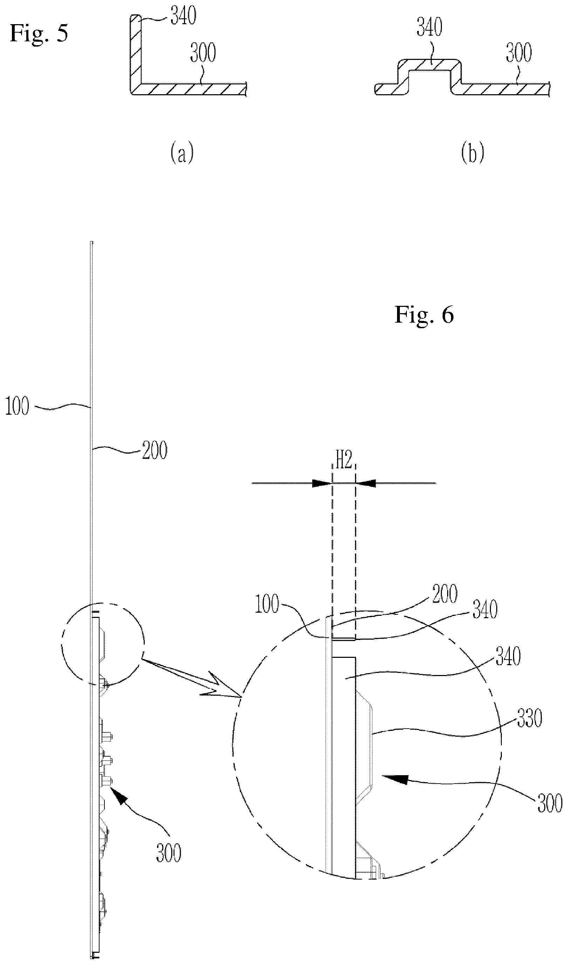

FIG. 4 is an exploded perspective view illustrating a display device according to another embodiment of the present disclosure, FIGS. 5A and 5B are cross-sectional views illustrating various examples of a reinforcing rib, which is a major part of FIG. 4, and FIG. 6 is a side view illustrating a UDM plate in detail, which is a major part of FIG. 4.

The display device of the present embodiment includes a UDM plate 300 at which a reinforcing rib 340 whose edge end portion protrudes outward (in a rear surface direction) is formed. As shown in FIG. 5A, the reinforcing rib 340 may be formed by bending four edges of a fastening end 320 in the rear surface direction into a shape of "L", or as shown in FIG. 5B, the reinforcing rib 340 may be formed to be convex in a shape of "U".

Further, the reinforcing rib 340 protrudes to have a predetermined height H2. The reinforcing rib 340 improves the resistance of the UDM plate 300 against bending deformation, which results in reinforcing the rigidity of a back cover 200. In this case, the performance of reinforcing the rigidity of the back cover 200 may be varied according to the protruding height H2 of the reinforcing rib 340. The reinforcing performance of the back cover 200 with respect to the UDM plate 300 of the present embodiment will be described in detail through an experiment below.

### <Experiment 2>

In Experiment 2, the amount of bending deformation was measured for the back cover, to which the UDM plate 300 having the reinforcing rib 340 is coupled, according to the present embodiment and the back cover, which has the UDM area (see a reference numeral "21" in FIG. 1) integrally formed therewith, according to the related art, and the results are shown in Table 2.

Experimental conditions were as follows, lower left and right corners and an upper left corner of a 50-inch (127 cm) back cover were fixed, and an upper right corner thereof was pressurized with a force of 5 kgf (49.33 N). In addition, a reinforcing frame joined with the conventional back cover had a " 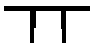 " shape (see a reference numeral "30" in FIG. 1) (Comparative Example 2), and a height H2 of reinforcing ribs 340 formed on the UDM plate 300 coupled to the back cover of the present embodiment was changed to 5 mm, 7 mm, 10 mm, and 12 mm (Experimental Examples 4 to 7).

**[Table 2]**

| Evaluation items | Comparative Example 2 | Experimental Example 4 | Experimental Example 5 | Experimental Example 6 | Experimental Example 7 |
|---|---|---|---|---|---|
| Rib Height (mm) | - | 5 | 7 | 10 | 12 |
| Deformation amount (mm) | 43.2 | 29.4 | 22.7 | 16.25 | 16.26 |

As can be seen from Table 2, when the force of 5 kgf (49.33 N) was applied to the upper right corner, a deformation amount of 43.2 mm was obtained for the conventional back cover, but deformation amounts of 29.4 mm (Experimental Example 4), 22.7 mm (Experimental Example 5), 16.25 mm (Experimental Example 6), and 16.26 mm (Experimental Example 7) were obtained for the back cover according to the present embodiment, and thus it can be seen that the deformation amount was significantly reduced. In addition, in the present embodiment, the deformation amount becomes smaller as the reinforcing rib 340 is formed to have a great height, thereby improving the function of reinforcing the back cover 200. However, when the height H2 of the reinforcing rib 340 is 7 mm or less, the reinforcing effect is not great compared to the increase in height, and when the height H2 of the reinforcing rib 340 is greater than 12 mm, the reinforcing effect is slightly increased compared to the amount by which the height is increased. Accordingly, when the height of the reinforcing rib 340 is in the range of 8 mm to 12 mm, the UDM plate 300 exhibits a relatively excellent reinforcing effect, and particularly when the height of the reinforcing rib 340 is 10 mm, the deformation amount is reduced by about 62% compared to the conventional back cover.

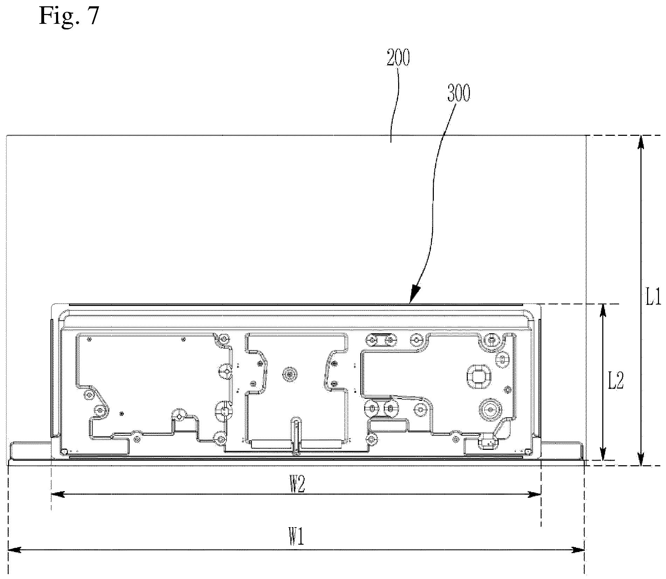

FIG. 7 is a rear view illustrating the display device according to the embodiment illustrated with reference to FIG. 4.

In the display device according to the present embodiment, the rigidity of the back cover 200 may be varied according to the overlapping area of the back cover 200 and the UDM plate 300, that is, the size of the UDM plate 300. In general, as the UDM plate 300 becomes larger, the performance of reinforcing the back cover becomes excellent, but the display device becomes heavy and the manufacturing cost according to material costs is increased, and accordingly, it is preferable that the UDM plate 300 has a size as small as possible within the range of sufficiently reinforcing the back cover.

As shown in FIG. 6, the UDM plate 300 is disposed at a central area of a lower end portion of the back cover 200, and the rigidity of the back cover 200 may vary according to vertical and lateral widths of the UDM plate. Based on a 55-inch (139.7 cm) or 65-inch (165.1 cm) display device, it is preferable that a clean back ratio in a vertical direction is in a range of 40% to 60%, and a clean back ratio in a lateral direction varies depending on the model and is approximately around 10%. In particular, in a horizontal display device that is relatively long in the lateral direction, the clean back ratio in the lateral direction becomes a major factor for bending deformation. Here, the clean back ratio refers to a ratio ((L1-L2)/L1) of a portion excluding a length L2 of the UDM plate 300 from an entire length L1 of the back cover 200 in the vertical direction with respect to the entire length LI, or a ratio ((W1-W2)/W1) of a portion excluding a width W2 of the UDM plate 300 from an entire width W1 of the back cover 200 in the lateral direction with respect to the entire width W1.

### <Experiment 3>

In Experiment 3, an amount of bending deformation of the back cover 200 according to the width W2 of the UDM plate 300 of the present embodiment was measured, and the results are shown in Table 3. In Experiment 3, the deformation amount was measured after applying a force of 5 kgf (49.33 N) to an upper left corner area of a back cover used in a 65-inch (165.1 cm) display device. In addition, experiments were performed on UDM plates 300 having a forming height H1 of 15 mm and a height H2 of a reinforcing rib 340 of 10 mm under conditions in which the clean back ratio ((L1-L2)/L1) in the vertical direction was set to 50% and the clean back ratio ((W1-W2)/W1) in the lateral direction was changed to 6%, 7%, 9%, 12%, and 15% (Experimental Examples 8 to 12).

**[Table 3]**

| Evaluation items | Experimental Example 8 | Experimental Example 9 | Experimental Example 10 | Experimental Example 11 | Experimental Example 12 |
|---|---|---|---|---|---|
| Clean back (%) | 6 | 7 | 9 | 12 | 15 |
| Deformation amount (mm) | 12.37 | 12.35 | 13.36 | 15.44 | 16.25 |

As can be seen from Table 3, as the clean back ratio in the lateral direction decreases, the deformation amount becomes smaller, thereby improving the function of reinforcing the back cover 200. In particular, when the clean back ratio in the lateral direction is in the range of 6% to 9%, the effect of reinforcing the back cover 200 is remarkable. According to the present disclosure, the rigidity of a back cover can be reinforced by a UDM plate, so that the structure of a display device can be simplified and manufacturing processes can be reduced.

Further, according to the present disclosure, the rigidity of a back cover can be easily controlled by using elements of a UDM plate such as a height, a length, a width, and a reinforcing rib.

In addition, according to the present disclosure, in correspondence with various models of a display device having the same size (inch (cm)), it is possible to change or replace only a UDM plate, so that mold costs can be reduced.

While exemplary embodiments of the present disclosure have been illustrated and described as described above, various modifications and equivalent other embodiments may be made by those skilled in the art.

## Claims

1. A back cover assembly for a display device comprising:
a back cover (200) configured to support a display panel (100) by bonding the display panel to a front surface thereof; and
a user-defined mount (UDM) plate (300) having a module-accommodating space (310), in which a module for driving the display panel (100) is accommodated, formed therein, and coupled to a rear surface of the back cover (200),
wherein the UDM plate (300) is formed to have a stepped portion of a predetermined height (HI) between a fastening end (320) fastened to the back cover (200) and a rear surface end (330) forming a rear surface of the UDM plate (300).

2. The back cover assembly for a display device of claim 1, wherein the back cover (200) is coupled to the UDM plate (300) by clinch bonding.

3. The back cover assembly for a display device of claim 1 or 2, wherein the UDM plate (300) is formed to have a stepped portion of 11 mm to 15 mm between the fastening end (320) and the rear surface end (330).

4. The back cover assembly for a display device of claim 1, 2 or 3, wherein the UDM plate (300) includes a reinforcing rib (340) formed by protruding an edge of the fastening end (320), which is fastened to the back cover (200), in a rear surface direction.

5. The back cover assembly for a display device of claim 4, wherein the reinforcing rib (340) is formed by bending an edge of the fastening end (320) into a shape of "L," or formed to be convex in a shape of "U."

6. The back cover assembly for a display device of claim 4 or 5, wherein the reinforcing rib (340) is formed to have a height of 8 mm to 12 mm with respect to the fastening end (320).

7. The back cover assembly for a display device of claim 6, wherein the UDM plate (300) has a clean back ratio ((W1 - W2)/W 1) of 6% to 9% in a lateral direction, wherein the clean back ratio is a ratio of a portion excluding a width (W2) of the UDM plate (300) from an entire width (W1) of the back cover (200) in the lateral direction with respect to the entire width (W1).

8. The back cover assembly for a display device of any of the preceding claims, wherein color coating or painting is performed on a surface of the back cover (200).

9. A display device comprising:
a display panel (100);
a back cover (200) configured to support the display panel (100) by bonding the display panel to a front surface thereof; and
a user-defined mount (UDM) plate (300) having a module-accommodating space (310), in which a module for driving the display panel (100) is accommodated, formed therein, and coupled to a rear surface of the back cover (200),
wherein the UDM plate (300) is formed to have a stepped portion of a predetermined height (HI) between a fastening end (320) fastened to the back cover (200) and a rear surface end (330) forming a rear surface of the UDM plate (300).

10. The display device of claim 9, wherein the UDM plate (300) includes a reinforcing rib (340) formed by bending an edge of the fastening end (320), which is fastened to the back cover (200), in a rear surface direction.
